# FASCICULE DE BREVET EUROPEEN

(11) **EP 0 377 242 B1**
(45) Date de publication et mention de la délivrance du brevet: **24.08.1994**
(21) Numéro de dépôt: 89203263.2
(22) Date de dépôt: 20.12.1989
(51) Int. Cl.: H03H 7/48

(54) **Dérivateur multiple avec voie de retour**
Mehrfachabzweigung mit Rückleitung
Multiple branch device with a return path

(30) Priorité: 27.12.1988 FR 8817226; 27.12.1988 FR 8817228
(43) Date de publication de la demande: 11.07.1990
(73) Titulaire: PHILIPS ELECTRONIQUE GRAND PUBLIC, 92150 Suresnes (FR); Philips Electronics N.V., 5621 BA Eindhoven (NL)
(72) Inventeur: Gris, Joel, F-75007 Paris (FR)
(74) Mandataire: Charpail, François

(56) Documents cités:
- EP-A- 0 053 675
- DE-A- 1 416 362
- DE-B- 2 827 961
- DE-C- 971 125
- FR-A- 1 253 266
- FR-A- 1 371 317
- GB-A- 867 499
- US-A- 3 619 504
- US-A- 4 156 212
- FUBA SPIEGEL, vol. 6, no. 2, 1961, pages 19-20; "Verlustarmer Stammleitungsverteiler GL 04"

## Description

La présente invention a pour objet un dérivateur multiple large bande avec voie de retour, comportant une entrée et une pluralité de sorties ayant une même impédance caractéristique Zₒ, constitué d'un répartiteur à réponse plate à résistances en étoiles pour une voie passe-bas combiné avec une cascade de dérivateurs directifs à lignes couplées pour une voie passe-haut, les sorties de ces deux dispositifs combinés étant connectées galvaniquement deux à deux pour constituer la dite pluralité de sorties.

Un tel dérivateur est notamment utilisé dans les installations d'antenne collective ou de diffusion de télévision par cable.

Du fait de l'extension des gammes d'ondes utilisées par les émetteurs, les réseaux de télévision doivent pouvoir transmettre la gamme 40-860 MHz (VHF et UHF), et la gamme 950-1750 MHz dite fréquence intermédiaire satellite.

Les dérivateurs directifs à lignes couplées ou en d'autres termes les coupleurs à ligne microstrip sont aujourd'hui largement utilisés pour réaliser des dérivateurs haute fréquence. Leur inconvénient est une réponse en amplitude périodique qui chute rapidement au voisinage des plus basses fréquences transmises. Un montage connu est décrit dans le brevet européen N° 53 675, dans ce montage un filtrage est nécessaire lequel entraîne l'existence d'une plage intermédiaire de fréquences inutilisables.

La présente invention a pour but de supprimer ces inconvénients.

Selon la présente invention, un dérivateur multiple est particulièrement remarquable en ce que l'entrée du répartiteur à résistances au centre de l'étoile est connectée à l'entrée du dérivateur multiple au moyen d'une connexion d'entrée comportant une impédance inductive Zₗ, en ce que l'entrée de la cascade de dérivateurs est connectée à l'entrée du dérivateur multiple au moyen d'une connexion d'entrée comportant une impédance capacitive Z_{c}, en ce que l'une des deux dites connexions d'entrée est aussi pourvue d'un élément inverseur de phase connecté en cascade pour remettre en phase sur toute la gamme de fréquence utilisée les signaux de la voie passe-haut et de la voie passe-bas, et en ce que Zₗ Z_{c} = Zₒ².

Ainsi le filtrage efficace et coûteux est remplacé par une séparation élémentaire avec seulement deux composants complémentaires, une bobine et un condensateur, qui présentent une fréquence de coupure commune à mi-énergie. Ils constituent une séparation en fréquence à deux voies et la somme des énergies transmises dans chaque voie est égale à l'énergie incidente à l'entrée du dispositif, ce qui permet une transmission sans bande intermédiaire perdue. Pour compenser les différences de phase à la sortie des deux voies et ainsi éviter les distorsions d'amplitude qui en résulteraient, un simple inverseur ramène exactement en phase les deux sorties. On peut alors sommer les deux signaux, après passage dans leurs dérivateurs respectifs, sans discontinuité de fréquence ni d'amplitude. Pour transmettre une voie retour en dessous de 40 MHz on peut utiliser également un montage qui associe un répartiteur apériodique à résistance et un coupleur à ligne. Un montage de ce genre est aussi décrit dans le brevet européen N° 53 675. Un inconvénient de ce montage est de nécessiter un filtrage efficace entre les deux bandes à transmettre sous peine de distorsions importantes dans la transmission. Le nombre de composants nécessaires pénalise alors le coût du produit. Ce filtrage impose de plus une distance entre les deux bandes ce qui entraîne l'existence d'une plage intermédiaire de fréquences inutilisables.

Une réalisation préférée est particulièrement remarquable en ce que le répartiteur à résistance en étoile est utilisé comme une voie de retour pour transmettre des signaux dans une direction opposée à la direction des signaux de la voie passe-haut.

La présente invention sera bien comprise avec la description non limitative d'exemples de réalisation illustrés par des figures.

La figure 1 représente un dérivateur multiple large bande avec voie de retour.

La figure 2 représente un dérivateur avec un répartiteur à résistance pour une distribution des signaux en aval.

La figure 3 représente un dérivateur avec un répartiteur à résistance comprenant des coupleurs à bobinage pour une distribution des signaux en aval.

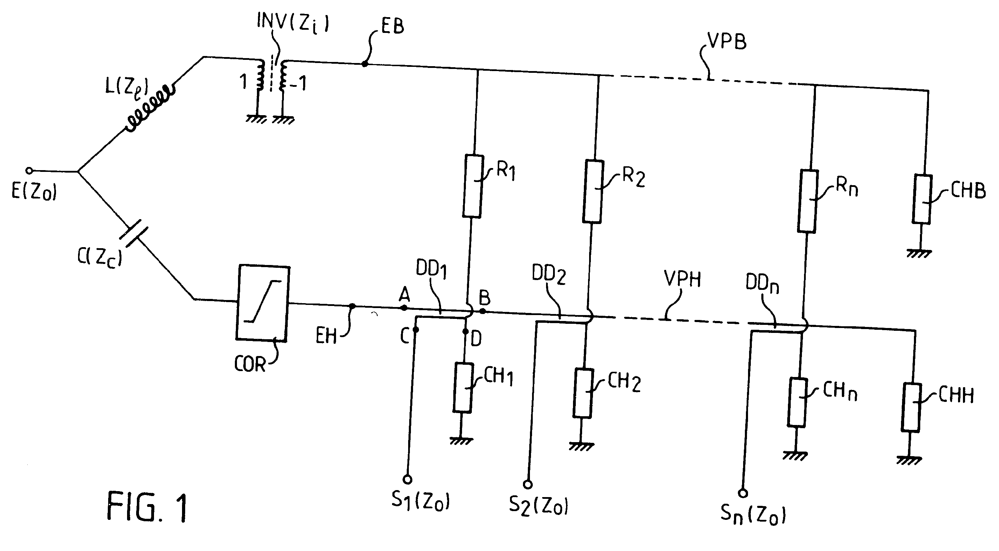

Le dérivateur de la figure 1 comporte une entrée E et 'n' sorties S₁, S₂,....,Sₙ dont les impédances caractéristiques sont toutes égales à Z₀; les sorties sont internement chargées sur leurs impédances caractéristiques CH₁, CH₂,...,CHₙ, égales à Z₀.

Le dérivateur comporte une voie passe-bas (VPB) constituée d'un répartiteur à résistances R₁, R₂,...,Rₙ, et une voie passe-haut (VPH) constituée par une cascade de dérivateurs directifs à lignes couplées ou en d'autres termes une cascade de coupleurs à ligne microstrip DD₁,DD₂,...,DDₙ. Chaque voie est terminée par une charge CHB, CHH; CHH est égale à Zₒ.

Les signaux présents à l'entrée sont séparés en fréquence par l'élément capacitif C d'impédance Z_{c} et par l'élément inductif L d'impédance Zₗ; l'inverseur INV d'impédance Zᵢ est ici représenté comme un transformateur de rapport unitaire inverseur de phase situé sur la connexion d'entrée du répartiteur à résistance c'est-à-dire sur la voie passe-bas mais ceci n'est pas une obligation; d'une part il existe d'autres types d'inverseur : ligne à déphasage, transistor,..., d'autre part il pourrait être situé sur la voie passe-haut.

Dans tous les cas, l'inverseur compense à toutes fréquences les différences de phase qui, sans sa présence, existeraient entre les deux voies.

De préférence l'inverseur de phase est apériodique par exemple un quadripole à 2 enroulements couplés mutuellement entre eux, les enroulements ayant une impédance Zᵢ très supérieure à Zₒ.

Les sorties du répartiteur et de la cascade de dérivateurs sont connectées galvaniquement deux à deux; en considérant les quatre poles A, B, C, D du quadripole DD₁, il est préférable de connecter la sortie de la résistance R₁ au pole D, c'est à dire sur la résistance de charge CH₁; ainsi tous les signaux circulant soit dans la voie passe-haut soit dans la voie passe-bas suivront le trajet DC et subiront de ce fait le même déphasage.

Ainsi les deux voies sont recombinées sans distorsion.

Les impédances Z_{c} et Zₗ ont des valeurs telles que: Z_{c}.Zₗ = Zₒ².

En conséquence, le condensateur C et la bobine L présentent une fréquence de coupure commune à mi-énergie, et la transmission s'effectue sans qu'il y ait une bande de fréquence intermédiaire inutilisable, par exemple entre 30 et 40 MHz, et l'on devrait maintenant parler de fréquence de recouvrement et non plus de fréquence de coupure.

Avec un tel dispositif, les transmissions, après passage dans leurs dérivateurs respectifs, s'effectuent sans aucune discontinuité de fréquence ni d'amplitude.

Avec un tel montage, la notion de voie de retour devient plutôt subjective. En effet, du fait qu'il n'y a plus de bande intermédiaire inutilisable, chaque fréquence peut circuler dans n'importe quel sens, aller ou retour, indifféremment.

Un tel dérivateur a été réalisé avec une entrée et huit sorties pour une installation d'antenne collective de télévision c'est à dire avec Zₒ=75 Ohm et une bande de fréquence comprise entre 40 et 860 MHz; dans ce cas la voie passe-bas constitue la voie de retour pour des signaux de fréquence inférieure à 40 MHz.

La voie de retour est avantageusement utilisée pour des signaux de péage, télécommande ou autres.

Dans cet exemple chiffré non limitatif on a retenu les valeurs de composants suivantes :
L = 210 nH; C = 38 pF.
Inverseur de plusieurs »Henry (Zᵢ).
R₁, R₂, R₃,...,R₈ = 1.000 Ohm.
CH₁, CH₂,...,CH₈ = 75 Ohm = CHH.
CHB = 200 Ohm.

La longueur des lignes couplées DD₁, DD₂,...,DD₈ est approximativement égale à λ/8 soit ici : 5 cm.

La voie passe-haut est munie d'un élément correcteur d'amplitude COR, c'est à dire d'un filtre qui adapte la réponse du montage à celle du cable.

Il est remarquable que le dérivateur multiple ainsi réalisé reste parfaitement opérationnel même si les normes de fréquences étaient modifiées; par exemple si les signaux de retour montent jusqu'à 80 MHz le montage peut rester inchangé, dans ce cas une partie des signaux de retour utilisera alors la voie passe-haut.

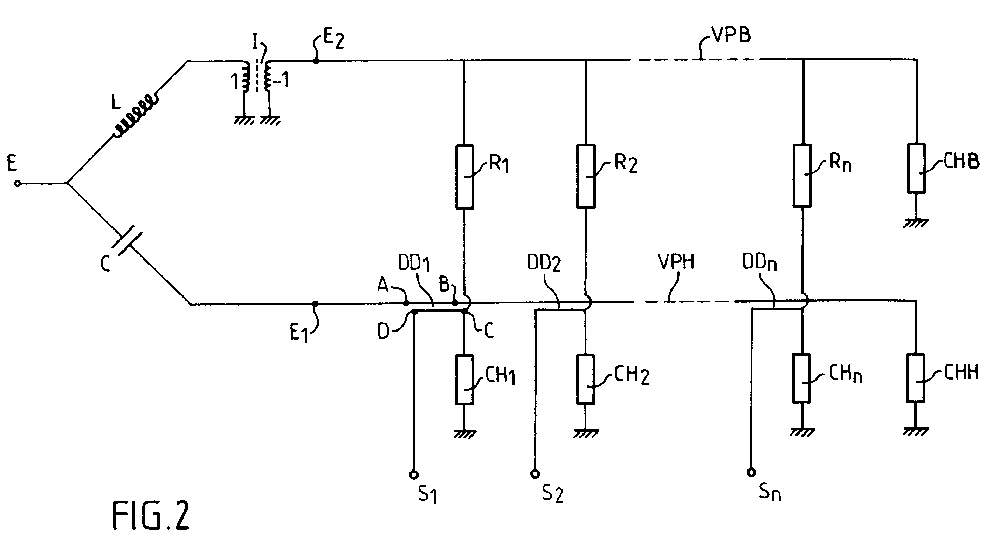

Le dérivateur de la figure 2 comporte une entrée E et une pluralité de sorties S₁, S₂,...,Sₙ; les valeurs des composants indiquées ci-après correspondent à un coupleur à 8 sorties dont le coupleur à ligne est centré sur 1750 MHz et dont la fréquence de recouvrement est de 100 MHz mais ceci n'est pas une limitation.

Pour une impédance d'entrée (Z₀) classique de 75 Ohm, les sorties sont aussi chargées sur la même valeur c'est-à-dire CH₁=CH₂=...=CHₙ=75 Ohm.

La cascade de coupleur à lignes (DD₁,DD₂,...,DDₙ) constitue la voie passe-haut (VPH) qui se termine sur la charge CHH de valeur 75 Ohm.

Le répartiteur à résistances R₁, R₂,...,Rₙ constitue la voie passe-bas (VPB) qui se termine sur une charge CHB égale à 200 Ohm; dans l'exemple choisi, les résistances sont égales et ont la valeur R₁=R₂=...=R₈=1000 Ohm.

L'entrée E₁ de la voie passe-haut (VPH) est connectée à l'entrée E à travers une capacité C de valeur de 15 pF (impédance Z_{c}).

L'entrée E₂ de la voie passe-bas (VPB) est connectée à l'entrée E à travers une self inductance L de valeur 84 nH (impédance Zₗ) et un inverseur I. Les valeurs Z_{c} et Zₗ sont calculées pour que :
- d'une part Z_{c} Zₗ=Zₒ²
- d'autre part la fréquence de recouvrement soit égale à 100 MHz.

L'inverseur I est un transformateur de rapport unitaire inverseur de phase.

L'inverseur I, dont l'impédance Zᵢ est très supérieure à Zₒ, permet de sommer sans distorsion en sortie les signaux qui suivent les deux parcours différents VPB et VPH, notamment pour la fréquence de recouvrement.

Si l'on considère le quadripole A, B, C, D constitué par le coupleur à lignes DD₁, il est avantageux que la résistance R₁ soit connectée au pole C plutôt qu'au pole D; ainsi tous les signaux circulant soit dans la voie passe-haut soit dans la voie passe-bas suivront le trajet CD et subiront de ce fait le même déphasage.

Il en est de même pour les autres quadripoles DD₂,...DDₙ, et les résistances R₂,....Rₙ.

L'exemple de la figure 2 est un schéma préférentiel. Toutefois certains éléments peuvent être situés autrement sans sortir du cadre de l'invention : par exemple l'inverseur I pourrait être connecté sur la voie passe-haut.

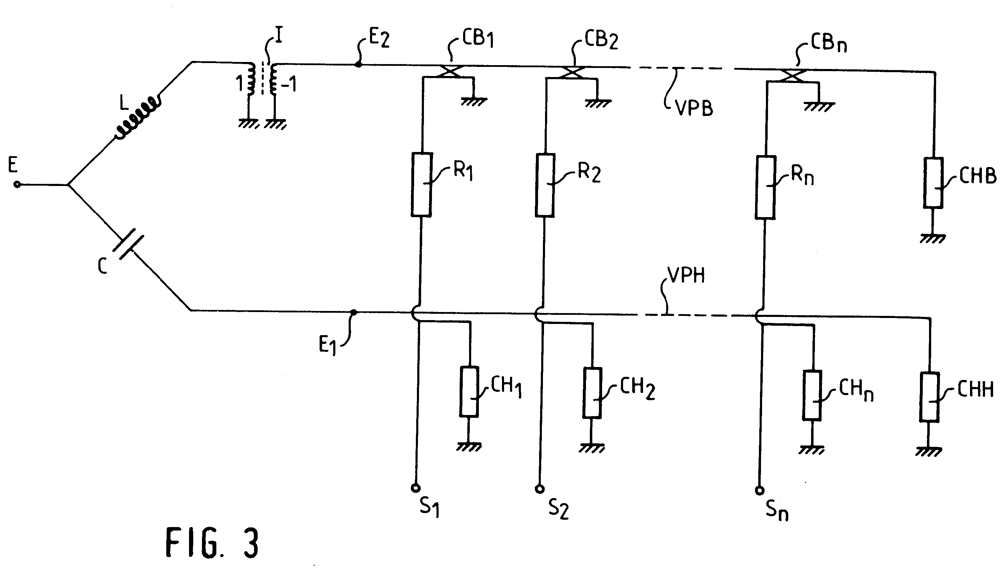

Le dérivateur de la figure 3 comporte des éléments similaires à ceux de la figure 2. Toutefois le répartiteur à résistance comprend des coupleurs à bobinage CB₁,CB₂,..., CBₙ, pour coupler l'entrée E₂ aux résistances R₁,R₂,..., Rₙ. La charge CHB a alors la valeur de 75 Ohm. A titre d'exemple, la fréquence de séparation a été choisie de 800 MHz ce qui provoque, toutes choses égales par ailleurs, les nouvelles valeurs pour la capacité C de 1,87 pF et de la self-inductance L de 10,4 nH; ces valeurs sont évidemment indicatives et nullement limitatives. Préférentiellement, chaque sortie du coupleur à bobinage est maintenant connectée sur la sortie correspondante du coupleur à ligne et non plus sur la charge.

## Revendications

1. Dérivateur multiple large bande comportant une entrée (E) et une pluralité de sorties (S₁ à Sₙ) ayant une même impédance caractéristique Zₒ, constitué d'un répartiteur à résistances (R₁ à Rₙ) en étoile pour une voie passe-bas (VPB) combiné avec une cascade de dérivateurs directifs à lignes couplées (DD₁ à DDₙ) pour une voie passe-haut (VPH), les sorties de ces deux dispositifs combinés étant connectées galvaniquement deux à deux pour constituer la dite pluralité de sorties, caractérisé en ce que l'entrée du répartiteur à résistances au centre de l'étoile est connectée à l'entrée du dérivateur multiple (E) au moyen d'une connexion d'entrée comportant une impédance inductive Z₁ (L), en ce que l'entrée de la cascade de dérivateurs est connectée à l'entrée du dérivateur multiple (E) au moyen d'une connexion d'entrée comportant une impédance capacitive Z_{c} (C), en ce que l'une des deux dites connexions d'entrée est aussi pourvue d'un élément inverseur de phase (INV,I) connecté en cascade pour remettre en phase sur toute la gamme de fréquence utilisée les signaux de la voie passe-haut et de la voie passe-bas, et en ce que
Zₗ Z_{c}=Zₒ².

2. Dérivateur multiple selon la revendication 1, caractérisé en ce que le répartiteur à résistances en étoile (R₁ à Rₙ) est utilisé comme une voie de retour pour transmettre des signaux dans une direction opposée à la direction des signaux de la voie passe-haut.

3. Dérivateur multiple selon la revendication 2 caractérisé en ce que l'élément inverseur de phase (INV,I) est apériodique.

4. Dérivateur multiple selon la revendication 3, caractérisé en ce que l'élément inverseur de phase (INV,I) est un quadripole à 2 enroulements couplés mutuellement entre eux, situé sur la connexion d'entrée du répartiteur à résistance, et dont les enroulements ont une impédance Zᵢ très supérieure à Zₒ.

5. Dérivateur multiple selon la revendication 4 caractérisé en ce que la modification du rapport des spires des enroulements de l'inverseur de phase permet de modifier l'impédance présentée au répartiteur à résistances.

6. Dérivateur multiple selon l'une quelconque des revendications 2, 3, 4 ou 5 caractérisé en ce que chacune des sorties du répartiteur à résistance est connectée sur la résistance de charge (CH₁ à CHₙ) de la sortie correspondante du coupleur à ligne.

7. Dérivateur multiple selon l'une quelconque des revendications 2, 3, 4, 5 ou 6, caractérisé en ce que la connexion d'entrée de la voie passe-haut (VPH) comporte en outre un élément correcteur d'amplitude (COR).

8. Dérivateur multiple selon l'une quelconque des revendications 4, 5, 6 ou 7, comportant 8 sorties adaptées à la distribution de signaux de télévision avec une voie passe-haut allant de 40 à 860 MHz, une voie passe-bas allant de 0 à 40 MHz, avec Zₒ=75 Ohm, caractérisé en ce que l'élément inductif (L) a une valeur d'environ 210 nHenry, l'élément capacitif (C) a une valeur d'environ 38 pFarad, les enroulements de l'inverseur ont une valeur de plusieurs »Henry, les résistances de charge (CH₁, CH₂,...CHₙ) des sorties du coupleur à ligne et de terminaison (CHH) de la voie passe-haut (VPH) ont une valeur de 75 Ohm, la résistance (CHB) de terminaison de la voie passe-bas (VPB) CHB a une valeur de 200 Ohm, les résistances du répartiteur à résistances (R₁, R₂,...Rₙ) ont une valeur de 1000 Ohm, et la longueur de chaque ligne couplée (DD₁,...DDₙ) est sensiblement égale à 5 cm.

9. Dérivateur multiple selon la revendication 1 centré sur 1750 MHz caractérisé en ce que les impédances Z_{c} et Zₗ définissent une fréquence dite de recouvrement à mi-énergie, laquelle est d'environ 100 MHz, et en ce que chaque sortie du répartiteur à résistance (R₁ à Rₙ) est connectée sur l'impédance caractéristique Zₒ de la sortie correspondante du dérivateur directif à ligne couplée.

10. Dérivateur multiple selon la revendication 1 centré sur 1750 MHz caractérisé en ce que le répartiteur à résistances en étoile (R₁ à Rₙ) comprend des coupleurs à bobinage, en ce que les impédances Z_{c} et Zₗ définissent une fréquence dite de recouvrement à mi-énergie, laquelle est d'environ 800 MHz, et en ce que chaque sortie du coupleur à bobinage est connectée sur la sortie correspondante du dérivateur directif à ligne couplée.

## Patentansprüche

1. Breitband-Mehrfachabzweiger, der einen Eingang (E) und eine Vielzahl von Ausgängen (S₁ bis Sₙ) mit gleicher charakteristischer Impedanz Z₀ umfaßt und von einem Widerstandsverteiler mit sternförmig angeordneten Widerständen (R₁ bis Rₙ) für eine Tiefpaßstrecke (VPB) in Kombination mit einer Kaskadenschaltung von Richtungskopplern mit gekoppelten Leitungen für eine Hochpaßstrecke (VPH) gebildet wird, wobei die Ausgänge dieser beiden kombinierten Anordnungen paarweise galvanisch verkoppelt sind, um die genannte Vielzahl von Ausgängen zu bilden, dadurch gekennzeichnet, daß der Eingang des Widerstandsverteilers mit sternförmig angeordneten Widerständen in der Mitte des Sterns mit dem Eingang (E) des Mehrfachabzweigers mittels einer Eingangsverbindung verbunden ist, die eine induktive Impedanz Z₁ (L) umfaßt, daß der Eingang der Kaskadenschaltung von Kopplern mit dem Eingang (E) des Mehrfachabzweigers mittels einer Eingangsverbindung verbunden ist, die eine kapazitiven Impedanz Z_{C} (C) umfaßt, daß eine der zwei genannten Eingangsverbindungen außerdem mit einem Phaseninvertierelement (INV, I) in Kaskadenschaltung versehen ist, um die Signale der Hochpaßstrecke und der Tiefpaßstrecke im gesamten verwendeten Wellenbereich wieder gleichphasig zu machen, und daß
Z₁ Z_{C} = Z₀².

2. Mehrfachabzweiger nach Anspruch 1, dadurch gekennzeichntet, daß der Widerstandsverteiler mit sternförmig angeordneten Widerständen (R₁ bis Rₙ) als Rückkanal verwendet wird, um Signale in einer Richtung zu übertragen, die der Richtung der Signale der Hochpaßstrecke entgegengesetzt ist.

3. Mehrfachabzweiger nach Anspruch 2, dadurch gekennzeichnet, daß das Phaseninvertierelement (INV, I) aperiodisch ist.

4. Mehrfachabzweiger nach Anspruch 3, dadurch gekennzeichnet, daß das Phaseninvertierelement (INV, I) ein Vierpol mit zwei miteinander gekoppelten Wicklungen ist, wobei die Wicklungen eine Impedanz Zᵢ haben, die sehr viel größer ist als Z₀.

5. Mehrfachabzweiger nach Anspruch 4, dadurch gekennzeichnet, daß die Veränderung des Verhältnis der Windungen der Wicklungen des Phaseninvertierers die Veränderung der dem Widerstandsverteiler gebotenen Impedanz ermöglicht.

6. Mehrfachabzweiger nach einem der Ansprüche 2, 3, 4 oder 5, dadurch gekennzeichnet, daß jeder der Ausgänge des Widerstandsverteilers mit dem Lastwiderstand (CH₁ bis CHₙ) des entsprechenden Ausgangs des Leitungskopplers verbunden ist.

7. Mehrfachabzweiger nach einem der Ansprüche 2, 3, 4, 5 oder 6, dadurch gekennzeichnet, daß die Eingangsverbindung der Hochpaßstrecke (VPH) außerdem ein Amplitudenkorrekturelement (COR) umfaßt.

8. Mehrfachabzweiger nach einem der Ansprüche 4, 5, 6 oder 7 mit acht Ausgängen, die für die Verteilung von Fernsehsignalen vorgesehen sind, mit einer Hochpaßstrecke von 40 bis 860 MHz und einer Tiefpaßstrecke von 0 bis 40 MHz mit Z₀ = 75 Ohm, dadurch gekennzeichnet, daß das induktive Element (L) einen Wert von ungefähr 210 nHenry hat, das kapazitive Element (C) einen Wert von ungefähr 38 pFarad hat, die Wicklungen des Invertierers einen Wert von mehreren »Henry haben, die Lastwiderstände (CH₁, CH₂, ... CH₈) der Ausgänge des Leitungskopplers und der Abschlußwiderstand (CHH) der Hochpaßstrecke (VPH) einen Wert von 75 Ohn haben, der Abschlußwiderstand (CHB) der Tiefpaßstrecke (VPB) einen Wert von 200 Ohm hat, die Widerstände (R₁, R₂, ... R₈) des Widerstandsverteilers einen Wert von 1000 Ohm haben, und die Länge jeder gekoppelten Leitung (DD₁,... DD₈) im wesentlichen gleich 5 cm ist.

9. Auf 1750 MHz zentrierter Mehrfachabzweiger nach Anspruch 1, dadurch gekennzeichnet, daß die Impedanzen Z_{C} und Z₁ bei halber Energie eine Überlappungsfrequenz genannte Frequenz definieren, die ungefähr 100 MHz beträgt, und daß jeder Ausgang des Widerstandsverteilers (R₁ bis Rₙ) mit der charakteristischen Impedanz Z₀ des entsprechenden Ausgangs des Richtungskopplers mit gekoppelter Leitung verbunden ist.

10. Auf 1750 MHz zentrierter Mehrfachabzweiger nach Anspruch 1, dadurch gekennzeichnet, daß der Widerstandsverteiler mit sternförmig angeordneten Widerständen (R₁ bis Rₙ) Spulenkoppler umfaßt, daß die Impedanzen Z_{C} und Z₁ bei halber Energie eine Überlappungsfrequenz genannte Frequenz definieren, die ungefähr 800 MHz beträgt, und daß jeder Ausgang des Spulenkopplers mit dem entsprechenden Ausgang des Richtungskopplers mit gekoppelter Leitung verbunden ist.

## Claims

1. A wideband multiple branch device having an input (E) and a plurality of outputs (S₁ to Sₙ) of the same characteristic impedance Z₀, constituted by an impedance arrangement in a star configuration (R₁ to Rₙ) for a low-pass path (VPB), and combined with a cascade arrangement of directional couplers (DD₁ to DDₙ) for a high-pass path (VHP), the outputs of these two combined arrangements being pair-wise dc connected to constitute said plurality of outputs, characterized in that the input of the impedance arrangement at the centre of the star is connected to the input (E) of the multiple branch device by means of an input connection comprising an inductive impedance Z₁ (L), in that the input of the cascade arrangement of branch devices is connected to the input (E) of the multiple branch device by means of an input connection comprising a capacitive impedance Z_{c} (C), in that one of said two input connections is also provided with a phase inverter element (INV, I) connected in cascade for restoring the phase of the signals of the high-pass path and the low-pass path throughout the used frequency range, and in that
Z₁ Z_{c} = Zₒ².

2. A multiple branch device as claimed in Claim 1, characterized in that the impedance arrangement (R₁ to Rₙ) in a star configuration is used as a return path for transmitting the signals in a direction opposite to the direction of the signals of the high-pass path.

3. A multiple branch device as claimed in Claim 2, characterized in that the phase inverter element (INV, I) is aperiodical.

4. A multiple branch device as claimed in Claim 3, characterized in that the phase inverter element is a quadripole having 2 windings which are mutually coupled and which are situated in the input connection of the impedance arrangement, the windings of said quadripole having an impedance Zᵢ which is much higher than Z₀.

5. A multiple branch device as claimed in Claim 4, characterized in that the modification of the ratio of turns of the phase inverter windings permit of modifying the impedance applied to the impedance arrangement.

6. A multiple branch device as claimed in any one of Claim 2, 3, 4 or 5, characterized in that each output of the impedance arrangement is connected to the load resistor (CH₁ to CHₙ) of the corresponding line coupler output.

7. A multiple branch device as claimed in any one of Claim 2, 3, 4, 5 or 6, characterized in that the input connection of the high-pass path (VHP) comprises *inter* *alia* an amplitude correction element (COR).

8. A multiple branch device as claimed in any one of Claim 4, 5, 6 or 7, comprising 8 outputs adapted to distribute television signals in a high-pass path of 40 to 860 MHz, a low-pass path of 0 to 40 MHz, with Zₒ = 75 Ω, characterized in that the inductive element (L) has a value of approximately 210 nHenry, the capacitive element (C) has a value of approximately 38 pFarad, the windings of the inverter have a value of several »Henry, the load resistors (CH₁, CH₂, ... CHₙ) of the outputs of the line coupler and the termination resistor (CHH) of the high-pass path (VPH) have a value of 75 Ω, the termination resistor (CHB) of the low-pass path (VPB) has a value of 200 Ω, the resistors (R₁, R₂, ... R₈) of the impedance arrangement have a value of 1000 Ω and the length of each coupled line (DD₁, ... DD₈ is substantially equal to 5 cm.

9. A multiple branch device centred at 1750 MHz as claimed in Claim 1, characterized in that the impedances Z_{c} and Z₁ define a frequency referred to as recovery frequency at half the energy, which is approximately 100 MHz, and in that each output of the impedance arrangement (R₁ to Rₙ) is connected to the characteristic impedance Z₀ of the corresponding directional coupler output.

10. A multiple branch device centred at 1750 MHz as claimed in Claim 1, characterized in that the impedance arrangement (R₁ to Rₙ) in a star configuration comprises coil couplers, in that the impedances Z_{c} and Z₁ define a frequency referred to as recovery frequency at half the energy, which is approximately 800 MHz, and in that each output of the coil coupler is connected to the corresponding directional coupler output.
